Europäisches Patentamt

European Patent Office

Office européen des brevets

(11) Veröffentlichungsnummer: **0 339 326**

**A2**

(12) **EUROPÄISCHE PATENTANMELDUNG**

(21) Anmeldenummer: 89106100.4

(51) Int. Cl.⁴: **H04B 9/00**

(22) Anmeldetag: 07.04.89

(30) Priorität: 27.04.88 DE 3814583

(43) Veröffentlichungstag der Anmeldung:
02.11.89 Patentblatt 89/44

(84) Benannte Vertragsstaaten:
AT BE CH DE ES FR GB GR IT LI LU NL SE

(71) Anmelder: KRONE Aktiengesellschaft
Beeskowdamm 3-11
D-1000 Berlin 37(DE)

(72) Erfinder: Aytac, Sungur, Dr.-Ing.
Celsiusstrasse 8
D-1000 Berlin 37(DE)
Erfinder: Huynh, Hon, Dipl.-Ing.
Lipschitzallee 46
D-1000 Berlin 47(DE)

(54) Verfahren und Vorrichtung zum Ansteuern von in einem optischen Sender eines Nachrichtenübertragungssystems eingesetzten Laserdioden.

(57) Gegenstand der Erfindung sind Verfahren und Anordnungen zum Ansteuern von Laserdioden, die in einem optischen Sender eines Nachrichtenübertragungssystems zum Einsatz kommen.

Dabei wird mit Multimoden-Laserdioden mit passiver Wellenführung gearbeitet, die zur Verbreiterung des emittierren Spektrums nach der Superimpositions-Methode betrieben werden. Zur Vermeidung von für die Nachrichtenübertragung störendem Jitter ist gemäß der Erfindung die Einhaltung einer starren Phasenbeziehung zwischen dem Nachrichtensignal ($S_D$) und dem überlagerten Hochfrequenzsignal ($S_{HF}$) oder dessen Unwirksammachung jeweils am Anfang und am Ende einer periodendauer ($T_D$) des Nachrichtensignals ($S_D$) während einer im Vergleich zu dieser Periodendauer ($T_D$) kleinen Zeitdauer ($T_{HF}$) vorgesehen.

**FIG.1**

## Verfahren und Vorrichtungen zum Ansteuern von in einem optischen Sender eines Nachrichtenübertragungssystems eingesetzten Laserdioden

Die Erfindung betrifft ein Verfahren zum Ansteuern von in einem optischen Sender eines Nachrichtenübertragungssystems eingesetzten Laserdioden, wie es im Oberbegriff des Patent-anspruchs 1 im einzelnen angegeben ist, sowie Anordnungen zum Durchführen eines solchen Verfahrens.

In Nachrichtenübertragungssystemen wird heute vielfach mit Nachrichtenübertragung auf optischem Wege über Lichtleiter gearbeitet, wobei optische Sender mit gesteuerten Multimoden- oder Einmoden-Laserdioden als Lichtquellen eingesetzt werden. Für Multimoden-Übertragungsstrecken sind aus Gründen der Betriebsstabilität durch Unterdrückung des Modenrauschens solche Laserdioden bevorzugt, die ein Laserlichtspektrum mit einer Mehrzahl von Spektrallinien emittieren. Die aus Stabilitätsgründen und langen Lebensdauer bevorzugten Multimoden-Laserdioden mit passiver Wellenführung (index-guided-Laser) erzeugen nun aber ein nur sehr schmal bandiges Spektrum, was deswegen ungünstig ist, weil daraus eine hohe Empfindlichkeit des gesamten Übertragungssystems gegen reflektierte Lichtwellen und starkes Modenrauschen mit Beeinträchtigung der Übertragungsqualität resultieren.

Ein üblicher Weg (vgl. DE-34 29 255-A1) zur Erzielung einer künstlichen Verbreiterung des emittierten Spektrums ist die Superimpositions-Methode, bei der dem der Laserdiode zu ihrem Betrieb zugeführten Gleichstrom ein Hochfrequenzstrom überlagert wird, um den Laservorgang mit hoher Geschwindigkeit im Sinne eines Ein/Aus-Betriebs zu modulieren, wobei der Longitudinalmode des Lasers zum Multimode wird. Im praktischen Betrieb eines entsprechenden optischen Senders in einem Nachrichtenübertragungssystem wird das der Laserdiode zugeführte Nachrichtensignal mit einem Hochfrequenzsignal überlagert. Dabei ergibt sich jedoch eine Schwierigkeit daraus, daß das so erhaltene Ausgangssignal so starkem Jitter unterliegt, daß in vielen Fällen eine zuverlässige Nachrichtenübertragung nicht mehr möglich ist. Zwar kann eine gewisse Abhilfe durch eine Erhöhung der Frequenz des überlagerten Hochfrequenzsignals geschaffen werden, doch ergeben sich hierbei rasch nicht zu überschreitende Grenzen, wobei der wesentliche Grund darin liegt, daß zur Erzielung eines ausreichenden Modulationsgrades und damit hinreichender Rauschreduzierung die Frequenz des Hochfrequenzsignals das Zweifache der Resonanzfrequenz der jeweiligen Laserdiode nicht überschreiten sollte.

Der Erfindung liegt daher die Aufgabe zugrunde, einen Weg aufzuzeigen, wie ausgehend von einem Verfahren der eingangs erwähnten Art eine auch bei hohen Anforderungen an die Übertragungsqualität ausreichende Jitterfreiheit des Modulationssignals erreicht werden kann.

Die gestellte Aufgabe wird gemäß der Erfindung gelöst durch ein Verfahren, wie es im Patentanspruch 1 angegeben ist. Vorteilhafte Ausgestaltungen dieses Verfahrens und Anordnungen zu seiner Durchführung sind aus den Unteransprüchen ersichtlich.

Für die weitere Erläuterung der Erfindung wird nunmehr auf die Zeichnung Bezug genommen, in der bevorzugte Ausführungsbeispiele veranschaulicht sind, die alle Merkmale und Vorteile der Erfindung deutlich werden lassen. Dabei zeigen in der Zeichnung:

Fig. 1 ein Blockschaltbild für den Aufbau einer Anordnung zum Ansteuern einer Laserdiode nach einem ersten Ausführungsbeispiel der Erfindung,

Fig. 2 ein entsprechendes Blockschaltbild für eine Anordnung zum Ansteuern einer Laserdiode nach einem zweiten Ausführungsbeispiel der Erfindung,

Fig. 3 ein entsprechendes Blockschaltbild für eine Anordnung zum Ansteuern einer Laserdiode nach einem dritten Ausführungsbeispiel für die Erfindung,

Fig. 4 eine Realisierungsmöglichkeit für eine Signalaufbereitungsschaltung im Rahmen der Blockschaltbilder von Fig. 2 oder 3 anhand eines Prinzipschaltbildes,

Fig. 5 Zeitdiagramme zur Veranschaulichung von an verschiedenen Stellen des Schaltbildes von Fig. 4 auftretenden Signalen und

Fig. 6 eine entsprechende Diagrammdarstellung unter besonderer Berücksichtigung des Ausführungsbeispiels nach Fig. 3.

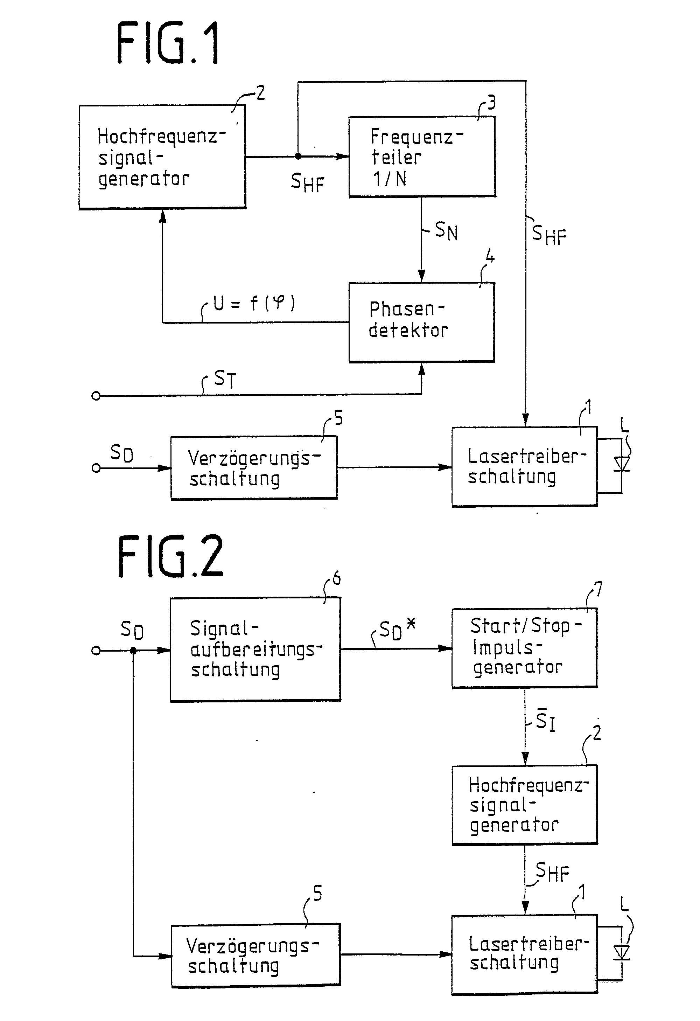

Das in Fig. 1 in Form eines Blockschaltbildes veranschaulichte erste Ausführungsbeispiel der Erfindung beruht auf der Erkenntnis, daß sich Jitterfreiheit eines durch Überlagerung eines Nachrichtensignals $S_D$ mit einem Hochfrequenzsignal $S_{HF}$ mit gegenüber der Frequenz $f_D$ des Nachrichtensignals $S_D$ großer Frequenz $f_{HF}$ erhaltenen Modulationssignals dann erzielen läßt, wenn zwischen dem Nachrichtensignal $S_D$ und dem Hochfrequenzsignal $S_{HF}$ eine feste Phasenbeziehung besteht. Die in Fig. 1 dargestellte Schaltung dient der Aufrechterhaltung einer solchen festen Phasenbeziehung zwischen dem Nachrichtensignal $S_D$ einerseits und dem Hochfrequenzsignal $S_{HF}$ andererseits.

Die in Fig. 1 gezeigte Anordnung ist für die Ansteuerung einer Laserdiode L bestimmt, die Teil eines optischen Senders für ein Nachrichtenübertragungssystem ist. Dazu weist die Anordnung von Fig. 1 eine Lasertreiberschaltung 1 auf, die der Laserdiode L die entsprechenden Steuerströme zuführt.

An einem ersten Eingang wird die Lasertreiberschaltung 1 von einem Hochfrequenzsignalgenerator 2 mit dem Hochfrequenzsignal $S_{HF}$ gespeist, während an einem zweiten Eingang der Lasertreiberschaltung 1 das Nachrichtensignal $S_D$ anliegt. In der Lasertreiberschaltung 1 selbst wird diesem Nachrichtensignal $S_D$ das Hochfrequenzsignal $S_{HF}$ unter Verwendung eines Mischers überlagert, um das Modulationssignal für die Ansteuerung der Laserdiode L zu gewinnen.

Die Einschaltung einer festen Phasenbeziehung zwischen den der Lasertreiberschaltung 1 zugeführten Signalen, nämlich zwischen dem Nachrichtensignal $S_D$ und dem Hochfrequenzsignal $S_{HF}$ aus dem Hochfrequenzsignalgenerator 2 geschieht bei dem dargestellten Ausführungsbeispiel durch eine passende Steuerung des in diesem Falle als spannungsgesteuerter Oszillator ausgebildeten Hochfrequenzsignalgenerators 2 mit Hilfe eines Phasenregelkreises. Dieser Phasenregelkreis enthält einen vom Hochfrequenzsignalgenerator 2 mit dem Hochfrequenzsignal $S_{HF}$ gespeisten Frequenzteiler 3 und einen an diesen mit einem ersten Eingang angeschlossenen Phasendetektor 4. Dieser Phasendetektor 4 wird an einem zweiten Eingang mit einem aus dem Nachrichtensignal $S_D$ entnommenen Taktsignal $S_T$ gespeist, und der Frequenzteiler 3 ist so ausgelegt, daß er das ihm vom Hochfrequenzsignalgenerator 2 zugeführte Hochfrequenzsignal $S_{HF}$ um einen Faktor 1/N auf die Frequenz des Taktsignals $S_T$ herunterteilt. Das auf diese Weise aus dem Hochfrequenzsignal $S_{HF}$ abgeleitete Signal $S_N$ wird dem Phasendetektor 4 an seinem mit dem Frequenzteiler 3 verbundenen ersten Eingang zugeführt. Im Phasendetektor 4 selbst werden die Signale $S_N$ und $S_T$ miteinander in ihrer Phasenlage verglichen, und das Ergebnis dieses Phasenvergleichs wird über den Ausgang des Phasendetektors 4 dem Hochfrequenzsignalgenerator 2 in Form einer Steuerspannung $U = f(\phi)$ als Steuersignal zugeführt, womit eine feste Phasenbeziehung zwischen dem Nachrichtensignal $S_D$ und dem vom Hochfrequenzsignalgenerator 2 an die Lasertreiberschaltung 1 abgegebenen Hochfrequenzsignal $S_{HF}$ sichergestellt ist, da der Hochfrequenzsignalgenerator 2 über den Phasenregelkreis aus dem Frequenzteiler 3 und dem Phasendetektor 4 Phasen starr im Takte des Nachrichtensignals $S_D$ geführt wird.

Die Zuführung des Nachrichtensignals $S_D$ zu dem zweiten Eingang der Lasertreiberschaltung 1 erfolgt unter Zwischenfügung einer Verzögerungsschaltung 5, deren Verzögerung $\tau$ für einen Ausgleich der Arbeitszeit im Phasenregelkreis aus dem Frequenzteiler 3 und dem Phasendetektor 4 sorgt.

Das in Fig. 2 dargestellte Blockschaltbild zeigt ein Ausführungsbeispiel für die Erfindung, das nach der Methode einer Ansteuerung mit Start/stop-Impulsen arbeitet.

Die in Fig. 2 gezeigte Anordnung ist wiederum für den Betrieb einer Laserdiode L bestimmt, die in einem optischen Sender eines Nachrichtenübertragungssystems enthalten ist. Für die unmittelbare Versorgung der Laserdiode L mit den notwendigen Steuerströmen sorgt wiederum eine Laserbetreiber schaltung 1 mit einem Mischer, die an einem ersten Eingang von einem Hochfrequenzsignalgenerator 2 her mit einem Hochfrequenzsignal $\dot{S}_{HF}$ gespeist wird. Einem zweiten Eingang der Lasertreiberschaltung 1 wird wiederum das Nachrichtensignal $S_D$ zugeführt, wobei dessen Frequenz $f_D$ wiederum klein ist gegenüber der Frequenz $f_{HF}$ des Hochfrequenzsignals $S_{HF}$.

Der Betrieb des Hochfrequenzsignalgenerators 2 vollzieht sich bei dem Ausführungsbeispiel von Fig. 2 unter Steuerung durch einen Start/Stop-Impulsgenerator 7, der dem Hochfrequenzsignalgenerator 2 vorgeschaltet ist und dafür sorgt, daß jeweils im Anschluß an jede positive oder Vorderflanke des Nachrichtensignals $S_D$ und vor jeder negativen oder Rückflanke des Nachrichtensignals $S_D$ wenigstens ein Impuls des Hochfrequenzsignals $S_{HF}$ am Ausgang des Hochfrequenzsignalgenerators 2 unterdrückt und damit für die Signalüberlagerung in der Lasertreiberschaltung 1 unwirksam gemacht wird. Diese Start/stop-Impulse sind in Fig. 2 durch ein Symbol $\overline{S}_I$ angedeutet.

Die Erzeugung der Start/Stop-Impulse $\overline{S}_I$ im Start/Stop-Impulsgenerator 7 erfolgt unter dessen Ansteuerung mit Hilfe des Nachrichtensignals $S_D$, wobei dem Start/Stop-Impulsgenerator 7 eine Signalaufbereitungsschaltung 6 vorgeordnet ist, die für einen entsprechenden Bezug der Start/stop-Impulse $\overline{S}_I$ zu den jeweiligen Flanken des Nachrichtensignals $S_D$ sorgt, wobei die entsprechenden Steuersignale für den Start/Stop-Impulsgenerator 7 aus der Signalaufbereitungsschaltung in Fig. 2 durch ein Symbol $S_D^*$ angedeutet sind.

Die Einspeisung des Nachrichtensignals $S_D$ zu dem zweiten Eingang der Lasertreiberschaltung 1 erfolgt über eine Verzögerungsschaltung 5', die für einen Ausgleich der Arbeitszeit in der Signalaufbereitungsschaltung 6 sorgt.

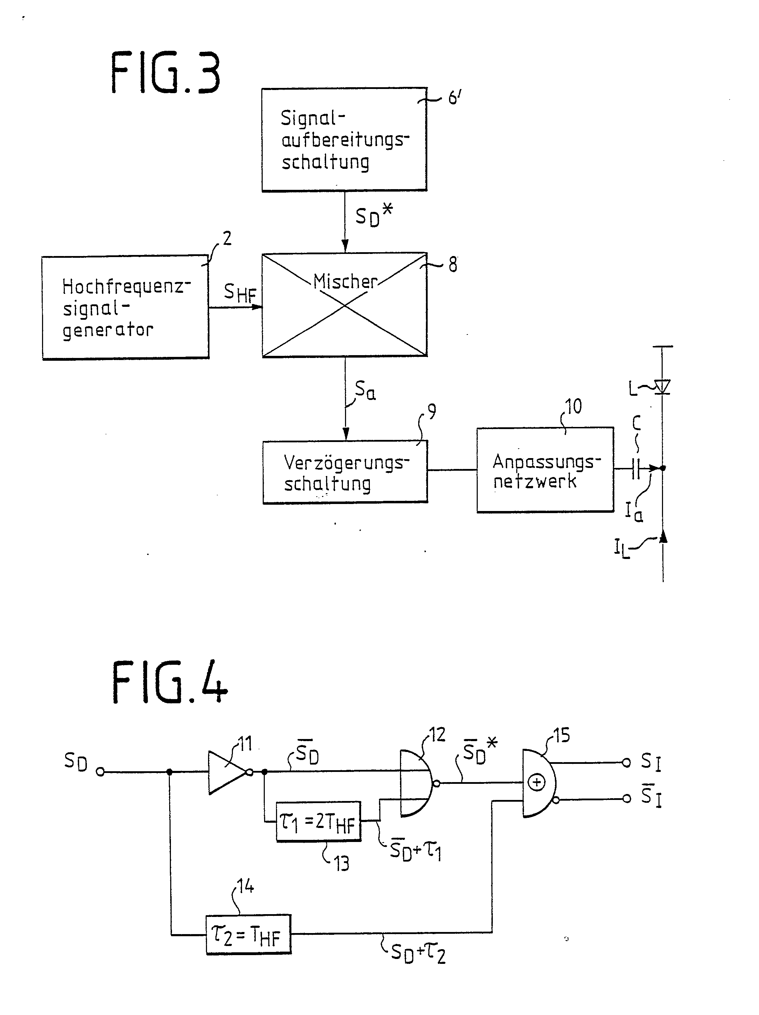

Eine Realisierungsmöglichkeit für den Aufbau der Signalaufbereitungsschaltung 6 und des angeschlossenen Start/Stop-Impulsgenerators 7 von Fig. 2 ist in Fig. 4 in Form eines schematischen Schaltbildes dargestellt, wobei auch die einzelnen Signale am Eingang bzw. am Ausgang der einzelnen Baustufen eingetragen sind.

Das in Fig. 4 gezeigte Schaltungsbeispiel weist einen mit dem Nachrichtensignal $S_D$ gespeisten Eingang und zwei Ausgänge auf, an denen Start/Stop-Impulse $S_I$ bzw. $\overline{S}_I$ abgenommen werden können, die zur Ansteuerung des Hochfrequenzsignalgenerators 2 in Fig. 2 dienen können.

Im Anschluß an den mit dem Nachrichtensignal $S_D$ gespeisten Eingang folgt in Fig. 4 zunächst ein Inverter 11, der eine ODER-Schaltung 12 an einem ersten Eingang direkt und an einem zweiten Eingang unter Zwischenschaltung einer Verzögerungsschaltung 13, die eine Verzögerung $\tau_1$ entsprechend der doppelten Periodendauer $2T_{HF}$ des Hochfrequenzsignals $S_{HF}$ bewirkt, mit dem invertierten Nachrichtensignal $\overline{S}_D$ bzw. $\overline{S}_D + \tau_1$ speist. An ihrem invertierenden Ausgang gibt die ODER-Schaltung 12 ein Signal $\overline{S}_D{}^*$ an einen ersten Eingang einer EXOR-Schaltung 15 ab, die außerdem an einem zweiten Eingang über eine Verzögerungsschaltung 14 mit einer Verzögerungszeit $\tau_2$ von einer Periodendauer T des Hochfrequenzsignals $S_{HF}$ mit dem Nachrichtensignal $S_D$ von dem entsprechenden Schaltungseingang her, also mit einem Signal $S_D + \tau_2$ gespeist wird. An den beiden Ausgängen der EXOR-Schaltung 15 können dann die Start/Stop-Impulse $S_I$ bzw. $\overline{S}_I$ für die Steuerung des Hochfrequenzsignalgenerators 2 in Fig. 2 abgenommen werden.

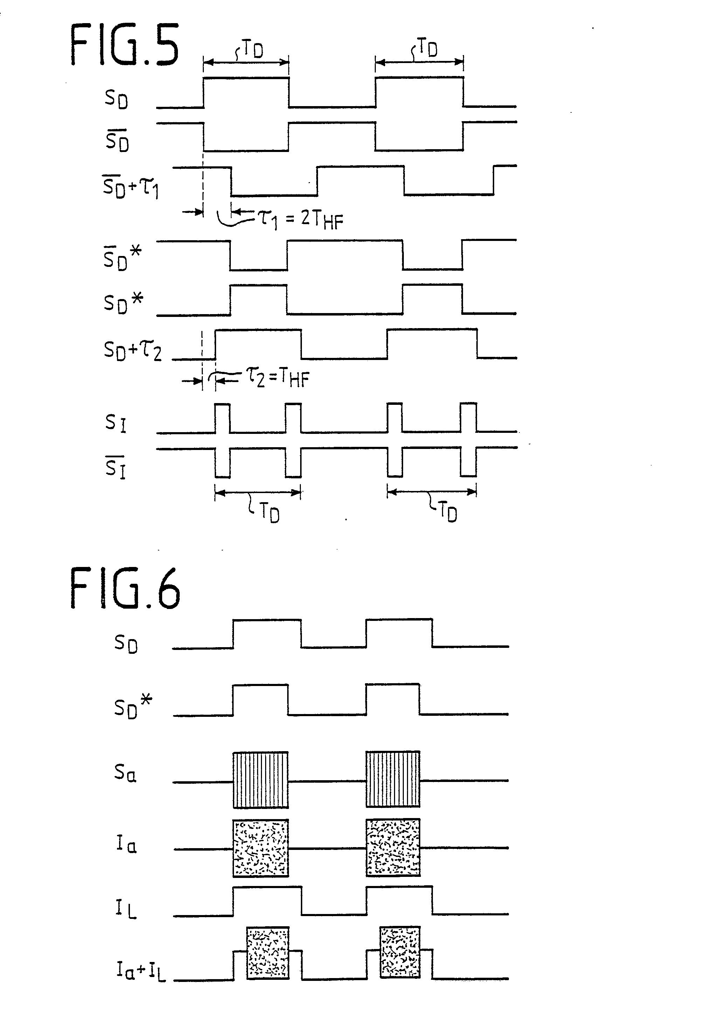

Der zeitliche Zusammenhang zwischen den verschiedenen Signalen in Fig. 4 ist in Diagrammform in Fig. 5 gezeigt, wobei in der Darstellung in Fig. 5 außer der Periodendauer $T_{HF}$ des Hochfrequenzsignals $S_{HF}$ auch die Periodendauer $T_D$ des Nachrichtensignals $S_D$ erscheint.

Das in Fig. 3 in Form eines Blockschaltbildes dargestellte dritte Ausführungsbeispiel für eine Anordnung gemäß der Erfindung dient zur Ansteuerung einer Laserdiode L, die mit einem Nachrichtenstrom $I_L$ gespeist wird und Bestandteil eines optischen Senders für ein Nachrichtenübertragungssystem ist, mit einem Steuerstrom $I_a$, der über einen Kondensator C in die den Strom $I_L$ führende Leitung zur Laserdiode L eingekoppelt wird. Dieses dritte Ausführungsbeispiel der Erfindung arbeitet nach der Methode einer Mischung des Nachrichtensignals $S_D$ einerseits und des Hochfrequenzsignals $S_{HF}$ andererseits, wobei dieses letzte Signal wiederum durch einen Hochfrequenzsignalgenerator 2 erzeugt wird, der aber bei diesem Ausführungsbeispiel einen Eingang eines beispielsweise als Ringmischer ausgeführten Mischers 8 mit dem Hochfrequenzsignal $S_{HF}$ beaufschlagt. An einem zweiten Eingang wird der Mischer 8 von einer Signalaufbereitungsschaltung 6' mit einem Signal $S_D{}^*$ gespeist, und an seinem Ausgang gibt der Mischer 8 ein Mischsignal $S_a$ an eine Verzögerungsschaltung 9 ab, von wo aus dieses Signal über ein Anpassungsnetzwerk 10 zu dem Kondensator C gelangt, von dem aus es dann in Form des Stromes $I_a$ in die den Strom $I_L$ zur Laserdiode L führende Leitung eingekoppelt wird.

Die Signalaufbereitungsschaltung 6' in Fig. 3 wird an einem Eingang mit dem Nachrichtensignal $S_D$ gespeist, und sie dient im wesentlichen dazu, dieses Nachrichtensignal $S_D$ in seiner Impulsbreite zu verkürzen, um das Signal $S_D{}^*$ zu erzeugen. Hinsichtlich der Einzelheiten dieser Impulsbreitenverkürzung für das Nachrichtensignal $S_D$ kann dabei auf das Schaltbild von Fig. 4 bzw. auf die Diagrammdarstellungen in Fig. 5 Bezug genommen werden, soweit sich diese auf die Erzeugung des Signals $S_D{}^*$ bzw. des Signals $S_D{}^*$ beziehen.

Die Gewinnung des Mischsignals $S_a$ aus dem in seiner impulsbreiteverkürzten Nachrichtensignal $S_D{}^*$ aus der Signalaufbereitungsschaltung 6' einerseits und dem Hochfrequenzsignal $S_{HF}$ aus dem Hochfrequenzsignalgenerator 2 andererseits geschieht in üblicher Weise und läßt sich ohne nähere Erläuterung aus der Diagrammdarstellung in Fig. 6 ersehen. Die dem Mischer 8 nachgeschaltete und mit dem Mischsignal $S_a$ gespeiste Verzögerungsschaltung 9 bewirkt eine Signalverzögerung um eine Periodendauer $T_{HF}$ des Hochfrequenzsignals $S_{HF}$, wodurch sich eine Phasenzentrierung des Mischsignals $S_a$ in bezug auf das Nachrichtensignal $S_D$ ergibt, die in der Diagrammdarstellung von Fig. 6 durch die ent sprechende Lage der Stromimpulse für die beiden einander überlagerten Ströme $I_a$ und $I_L$ veranschaulicht ist. Die Aufgabe des Anpassungsnetzwerkes 10 in Fig. 3 besteht darin, das Mischsignal $S_a$ aus dem Mischer 8 auf eine weiterverarbeitungsfähige Signalgröße zu bringen, was beispielsweise durch entsprechende Verstärkung geschehen kann, bevor dieses Mischsignal $S_a$ in Form des Stromes $I_a$ in die zur Laserdiode L führende Leitung eingekoppelt wird.

## Ansprüche

1. Verfahren zum Ansteuern von in einem optischen Sender eines Nachrichtenübertragungssystems eingesetzten Laserdioden, bei dem ein Modulationssignal für eine zu steuernde Laserdiode durch Überlagerung eines Nachrichtensignals mit einem Hochfrequenzsignal gewonnen wird, dessen Frequenz zwischen etwa dem halben Wert und etwa dem doppelten Wert der Resonanzfrequenz der Laserdiode liegt,
dadurch gekennzeichnet,
daß bei der Überlagerung des Nachrichtensignals ($S_D$) mit dem Hochfrequenzsignal ($S_{HF}$) das Nachrichtensignal ($S_D$) und das Hochfrequenzsignal ($S_{HF}$) in einer festen Phasenbeziehung zueinander gehalten werden oder das Hochfrequenzsignal (S$_{HF}$) jeweils am Anfang und am Ende einer Periodendauer (T$_D$) des Nachrichtensignals (S$_D$) während einer im Vergleich zu dieser Periodendauer (T$_D$) kleinen Zeitdauer (T$_{HF}$) unwirksam gemacht wird.

2. Verfahren nach Anspruch 1,
dadurch gekennzeichnet,
daß zur Erzielung einer festen Phasenbeziehung zwischen dem Nachrichtensignal (S$_D$) und dem Hochfrequenzsignal (S$_{HF}$) dessen Erzeugung durch das Ergebnis (U = f($\phi$)) eines Phasenvergleichs zwischen einem aus dem Hochfrequenzsignal (S$_{HF}$) abgeleiteten Signal (S$_N$) und einem dem Nachrichtensignal (S$_D$) entnommenen Taktsignal (S$_T$) gesteuert wird.

3. Verfahren nach Anspruch 1,
dadurch gekennzeichnet,
daß das Hochfrequenzsignal (S$_{HF}$) nach jeder positiven Flanke und vor jeder negativen Flanke des Nachrichtensignals (S$_D$) jeweils für die Dauer (T$_{HF}$) eines Impulses des Hochfrequenzsignals (S$_{HF}$) unterdrückt wird.

4. Verfahren nach Anspruch 1,
dadurch gekennzeichnet,
daß das Nachrichtensignal (S$_D$) zunächst in seiner Impulsbreite (T$_D$) um einen dagegen kleinen festen Wert (2T$_{HF}$) verringert und sodann mit dem Hochfrequenzsignal (S$_{HF}$) gemischt wird.

5. Anordnung zum Durchführen des Verfahrens nach Anspruch 1 oder 2 mit einem Hochfrequenzsignalgenerator zum Erzeugen des Hochfrequenzsignals und mit einer Lasertreiberschaltung, die an einem ersten Eingang mit dem Nachrichtensignal und an einem zweiten Eingang mit dem Hochfrequenzsignal aus dem Hochfrequenzsignalgenerator gespeist wird und das durch Überlagerung von Nachrichtensignal und Hochfrequenzsignal gewonnene Modulationssignal an die zu steuernde Laserdiode abgibt,
dadurch gekennzeichnet,
daß dem Hochfrequenzsignalgenerator (2) ein Frequenzteiler (3) nachgeschaltet ist, der die Frequenz (f$_{HF}$) des Hochfrequenzsignals (S$_{HF}$) auf die Frequenz (f$_T$) des Taktsignals (S$_T$) aus dem Nachrichtensignal (S$_D$) herunterteilt und das so abgeleitete Signal (S$_N$) einem Phasendetektor (4) zuführt, der außerdem mit dem Taktsignal (S$_T$) gespeist wird und das Ergebnis eines Phasenvergleichs zwischen den ihm zugeführten Signalen (S$_N$ und S$_T$) dem Hochfrequenzsignalgenerator (2) als Steuerspannung (U = f($\phi$)) zuführt, und daß dem mit dem Nachrichtensignal (S$_D$) gespeisten Eingang der Lasertreiberschaltung (1) eine Verzögerungsschaltung (5) vorgeschaltet ist, die das Nachrichtensignal (S$_D$) vor seiner Einspeisung in die Lasertreiberschaltung (1) zu seiner Überlagerung mit dem Hochfrequenzsignal (S$_{HF}$) um eine feste Zeitdauer ($\tau$) verzögert, die der Ansteuerzeit des Hochfrequenzsignalgenerators (2) über den Phasendetektor (4) entspricht.

6. Anordnung zum Durchführen des Verfahrens nach Anspruch 1 oder 3 mit einem Hochfrequenzsignalgenerator zum Erzeugen des Hochfrequenzsignals und mit einer Lasertreiberschaltung, die an einem ersten Eingang mit dem Nachrichtensignal und an einem zweiten Eingang mit dem Hochfrequenzsignal aus dem Hochfrequenzsignalgenerator gespeist wird und das durch Überlagerung von Nachrichtensignal und Hochfrequenzsignal gewonnene Modulationssignal an die zu steuernde Laserdiode abgibt,
dadurch gekennzeichnet,
daß dem Hochfrequenzsignalgenerator (2) nacheinander eine Signalaufbereitungsschaltung (6) und ein Start/Stop-Impulsgenerator (7) vorgeschaltet sind, von denen die Signalaufbereitungsschaltung (6) mit dem Nachrichtensignal (S$_D$) gespeist wird und dieses mit verkürzter Impulsbreite an den Start/Stop-Impulsgenerator (7) abgibt, der seinerseits in ihrer Breite der Impulsbreitenverkürzung entsprechende Start/Stop-Impulse mit umgekehrter Polarität an den Hochfrequenzsignalgenerator (2) abgibt, wo sie eine Impulsunterdrückung für das Hochfrequenzsignal (S$_{HF}$) jeweils im Anschluß an jede Vorderflanke und vor jeder Rückflanke des Nachrichtensignals (S$_D$) bewirken, und daß dem mit dem Nachrichtensignal (S$_D$) gespeisten Eingang der Lasertreiberschaltung (1) eine Verzögerungsschaltung (5') vorgeschaltet ist, die das Nachrichtensignal (S$_D$) vor seiner Einspeisung in die Lasertreiberschaltung (1) zu seiner Überlagerung mit dem Hochfrequenzsignal (S$_{HF}$) um eine feste Zeitdauer ($\tau$) verzögert, die der Ansteuerzeit des Hochfrequenzsignalgenerators (2) über die Signalaufbereitungsschaltung (6) und dem Start/Stop-Impulsgenerator (7) entspricht.

7. Anordnung zum Durchführen des Verfahrens nach Anspruch 1 oder 4 mit einem Hochfrequenzsignalgenerator zum Erzeugen des Hochfrequenzsignals,
dadurch gekennzeichnet,
daß dem Hochfrequenzsignalgenerator (2) ein Mischer (8) nachgeschaltet ist, der an einem zweiten Eingang über eine mit dem Nachrichtensignal (S$_D$) gespeiste Signalaufbereitungsschaltung (6') mit dem in seiner Impulsbreite um eine feste Zeitdauer (2T$_{HF}$) verkürzte Nachrichtensignal (S$_D^*$) gespeist wird und das durch Mischen des verkürzten Nachrichtensignals (S$_D^*$) mit dem Hochfrequenzsignal (S$_{HF}$) erhaltene Mischsignal (S$_a$) über eine Verzögerungsschaltung (9) für eine feste Signalverzögerung (T$_{HF}$) und ein Anpassungsnetzwerk (10) unter Einkopplung über einen Kondensator (C) dem Lasersteuerstrom ($I_L$) durch die zu steuernde Laserdiode (L) in Form eines Stromes ($I_a$) überlagert.

# FIG.1

```
┌─────────────────┐                    ┌──────────────┐
│ Hochfrequenz-   │ 2                  │ Frequenz-    │ 3
│ signal-         │───────●──────────→ │ teiler       │
│ generator       │    S_HF            │ 1/N          │
└─────────────────┘                    └──────────────┘
      ↑                                      │ S_N
      │ U = f(φ)                             ↓
      │              ┌──────────────┐
      └──────────────│ Phasen-      │ 4
                     │ detektor     │
         S_T         └──────────────┘
   o────────────────────────┘
                                            S_HF
   S_D   ┌──────────────┐       ┌──────────────┐ 1
   o────→│ Verzögerungs-│ 5     │ Lasertreiber-│    L
         │ schaltung    │──────→│ schaltung    │───▷
         └──────────────┘       └──────────────┘
```

# FIG.2

```
   S_D   ┌──────────────┐  S_D*  ┌──────────────┐ 7
   o──●──→│ Signal-      │ 6 ───→ │ Start/Stop-  │
      │   │ aufbereitungs│        │ Impuls-      │
      │   │ schaltung    │        │ generator    │
      │   └──────────────┘        └──────────────┘
      │                                 │ S̄_I
      │                           ┌──────────────┐ 2
      │                           │ Hochfrequenz-│
      │                           │ signal-      │
      │                           │ generator    │
      │                           └──────────────┘
      │                                 │ S_HF
      │   ┌──────────────┐ 5     ┌──────────────┐ 1
      └──→│ Verzögerungs-│       │ Lasertreiber-│    L
          │ schaltung    │──────→│ schaltung    │───▷
          └──────────────┘       └──────────────┘
```

# FIG.3

Signalaufbereitungsschaltung  6'

$S_D{}^*$

Hochfrequenzsignalgenerator  2

$S_{HF}$

Mischer  8

$S_a$

Verzögerungsschaltung  9

Anpassungsnetzwerk  10

L

C

$I_a$

$I_L$

# FIG.4

$S_D$

11  $\overline{S}_D$

12  $\overline{S}_D{}^*$

15  $S_I$

$\overline{S}_I$

$\tau_1 = 2T_{HF}$  13

$\overline{S}_{D+\tau_1}$

$\tau_2 = T_{HF}$  14

$S_{D+\tau_2}$

# FIG.5

$S_D$

$\overline{S_D}$

$\overline{S_D} + \tau_1$

$\tau_1 = 2T_{HF}$

$\overline{S_D}^*$

$S_D^*$

$S_D + \tau_2$

$\tau_2 = T_{HF}$

$S_I$

$\overline{S_I}$

$T_D$

# FIG.6

$S_D$

$S_D^*$

$S_a$

$I_a$

$I_L$

$I_a + I_L$